# EUROPEAN PATENT APPLICATION

(11) **EP 4 812 001 A1**
(43) Date of publication of application: **23.09.2026**
(21) Application number: 26156179.9
(22) Date of filing: 03.02.2026
(51) Int. Cl.: H10P 72/00, H10P 72/50

(54) **SUBSTRATE TREATMENT APPARATUS AND SUBSTRATE TREATMENT METHOD**

(30) Priority: 17.03.2025 JP 2025042645
(71) Applicant: SCREEN Holdings Co., Ltd., Kyoto-shi, Kyoto 602-8585 (JP)
(72) Inventor: SHIMIZU, Shinji, Kyoto, 602-8585 (JP)
(74) Representative: Kilian Kilian & Partner mbB

(57) **Abstract**

A monitoring region is set by efficient processing, and the presence or absence of an anomaly related to an operational state of a monitoring target article is monitored efficiently. A processor of a substrate treatment apparatus sets a monitoring region three-dimensionally based on three-dimensional design information pertaining to the substrate treatment apparatus, generates a normal image for each of timings during a normal operation carried out based on a recipe by two-dimensionalizing the monitoring region in a view from a placement position, and stores the normal image in a normal image storage unit before performing an actual treatment on the substrate. Further, during working in which the substrate is actually treated based on the recipe, the processor detects an anomaly on the basis of a difference between the normal image and the real image captured by the camera, which are synchronized with the operation based on the recipe.

## Description

### Technical Field

The present disclosure relates to a substrate treatment apparatus, a substrate treatment system, and a substrate treatment method that perform a predetermined treatment on a substrate, such as a semiconductor substrate, a substrate for flat panel display (FPD) in a liquid crystal display device, an organic electroluminescence (EL) display device, and the like, a glass substrate for photomask, and a substrate for optical disk. The present disclosure relates to, in particular, an apparatus that monitors an operational state of a component with use of an image.

### Background Art

In a machine vision system using a two-dimensional camera, a monitoring region corresponding to an image captured by the camera is set as a two-dimensional region such as a rectangular region, as disclosed in, for example, Patent Literature 1.

### Citation List

### [Patent Literature]

[Patent Literature 1]
Japanese Patent Application Publication Tokukai No. 2023-122222

### Summary of Invention

### Technical Problem

However, in a method of setting a monitoring region as a two-dimensional region, a distance between a monitoring target component and the camera and an orientation of the monitoring target component as viewed from the camera vary depending on the position to which the monitoring target component moves. Thus, the appearance of the monitoring target component in an image captured by the camera varies. To account for this, it becomes necessary to obtain images captured during a normal operation for all positions to which the monitoring target component moves, and to set a monitoring region for each captured image.

Further, even in a commonly used monitoring algorithm based on pattern matching, the appearance of the monitoring target component in an image captured by the camera varies depending on the position to which the monitoring target component moves. Thus, it is necessary to prepare an image captured during a normal operation for each position in order to perform pattern matching. In addition, it is also necessary to set a monitoring region for each position.

An object of an aspect of the present disclosure is to set a monitoring region by efficient processing and efficiently monitor the presence or absence of an anomaly related to an operational state of a monitoring target article.

### Solution to Problem

A substrate treatment apparatus in accordance with an aspect of the present disclosure is a substrate treatment apparatus configured to perform a predetermined treatment on a substrate, the apparatus including: a recipe storage unit configured to store a recipe that specifies details of an operation of a constituent component of the substrate treatment apparatus and an order of execution, in order to perform the predetermined treatment; an image capture unit provided at a predetermined placement position and configured to capture an image of the component as a real image; a normal image storage unit; a processor; and a memory, the processor being configured to carry out, in conjunction with the memory, the following processes (a) to (d):
(a) setting a monitoring region three-dimensionally on the basis of three-dimensional design information pertaining to the substrate treatment apparatus;
(b) for each of a plurality of timings during a normal operation carried out in accordance with the recipe, generating a normal image by two-dimensionalizing the monitoring region in a view from the placement position;
(c) before performing an actual treatment on the substrate, storing the normal image in the normal image storage unit; and
(d) during working in which the substrate is actually treated in accordance with the recipe, detecting an anomaly on the basis of a difference between the normal image and the real image captured by the image capture unit, the normal image and the real image being synchronized with an operation carried out in accordance with the recipe.

A substrate treatment method in accordance with an aspect of the present disclosure is a substrate treatment method carried out by a substrate treatment apparatus configured to perform a predetermined treatment on a substrate, the substrate treatment apparatus including: a recipe storage unit configured to store a recipe that specifies details of an operation of a constituent component of the substrate treatment apparatus and an order of execution, in order to perform the predetermined treatment; an image capture unit provided at a predetermined placement position and configured to capture an image of the component as a real image; and a normal image storage unit, wherein a computer including a processor and a memory is configured to, by causing the processor to operate in conjunction with the memory, carry out the following processes (a) to (d):
(a) setting a monitoring region three-dimensionally on the basis of three-dimensional design information pertaining to the substrate treatment apparatus;
(b) for each of a plurality of timings during a normal operation carried out in accordance with the recipe, generating a normal image by two-dimensionalizing the monitoring region in a view from the placement position;
(c) before performing an actual treatment on the substrate, storing the normal image in the normal image storage unit; and
(d) during working in which the substrate is actually treated in accordance with the recipe, detecting an anomaly on the basis of a difference between the normal image and the real image captured by the image capture unit, the normal image and the real image being synchronized with an operation carried out in accordance with the recipe.

### Advantageous Effects of Invention

According to an aspect of the present disclosure, it is possible to set a monitoring region by efficient processing and efficiently monitor the presence or absence of an anomaly related to an operational state of a monitoring target article.

### Brief Description of Drawings

Fig. 1 is a side view illustrating a substrate treatment apparatus in accordance with Embodiment 1.
Fig. 2 is a plan view of the substrate treatment apparatus in accordance with Embodiment 1.
Fig. 3 is a block diagram of the substrate treatment apparatus in accordance with Embodiment 1.
Fig. 4 is a view schematically illustrating a process of generating a normal image.
Fig. 5 illustrates an example of a recipe and is a schematic view illustrating details of the recipe.
Fig. 6 is a flowchart illustrating an example of a flow of a normal image generation process in the substrate treatment apparatus in accordance with Embodiment 1.
Fig. 7 is a flowchart illustrating an example of a flow of an anomaly detection process in the substrate treatment apparatus in accordance with Embodiment 1.
Fig. 8 is a schematic view for describing a comparison between a normal image and a real image during working of the apparatus.
Fig. 9 is a perspective view illustrating an example of a transport robot in accordance with Embodiment 2.

### Description of Embodiments

### Embodiment 1

### <1. Overall Configuration>

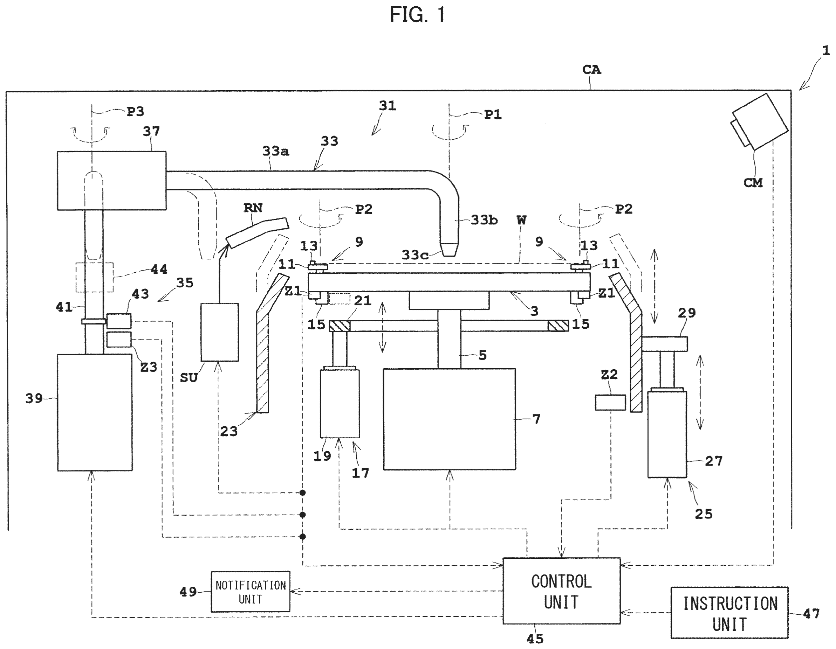

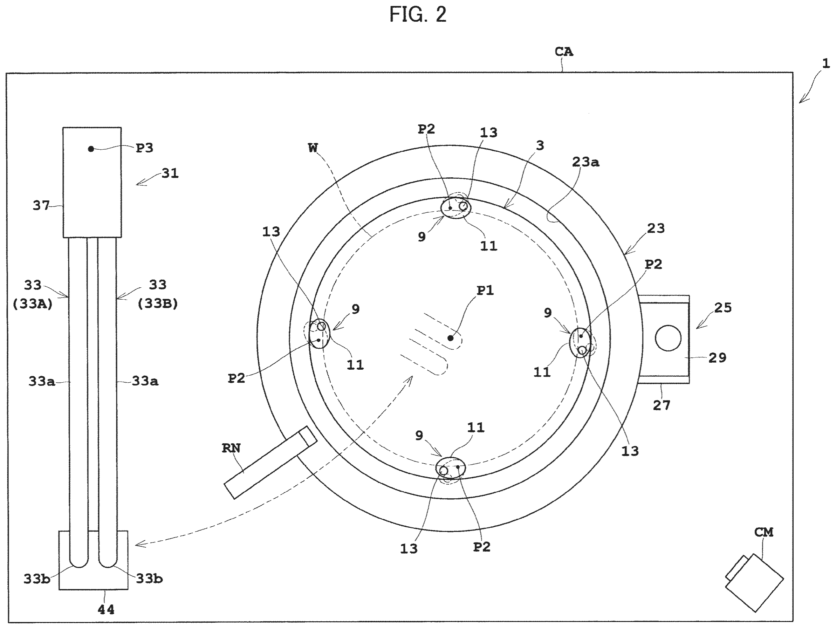

Fig. 1 is a side view illustrating a substrate treatment apparatus in accordance with Embodiment 1. Fig. 2 is a plan view of the substrate treatment apparatus in accordance with Embodiment 1.

A substrate treatment apparatus 1 is a single-substrate treatment apparatus that treats a substrate W on a one-by-one basis. The substrate W has, for example, a circular shape in plan view. The substrate treatment apparatus 1 performs a predetermined treatment on the substrate W by supplying a treatment liquid while rotating the substrate W.

The substrate treatment apparatus 1 includes a casing CA. The casing CA blocks the interior thereof from a surrounding atmosphere. The substrate treatment apparatus 1 includes a spin chuck 3. The spin chuck 3 supports the substrate W in a horizontal posture and rotates the substrate W. The spin chuck 3 has a circular shape that has a diameter larger than that of the substrate W in plan view. The spin chuck 3 has a lower surface connected to an upper end of a rotation shaft 5. A lower end of the rotation shaft 5 is connected to a motor 7. When the motor 7 is driven, the spin chuck 3 rotates about a rotation center P1. The rotation center P1 extends in a vertical direction.

The spin chuck 3 includes a plurality of chucks 9. The spin chuck 3 includes the plurality of chucks 9 at a peripheral edge of an upper surface thereof. In the present embodiment, the spin chuck 3 includes four chucks 9. The number of chucks 9 is not limited to four as long as the substrate W can rotate stably about the rotation center P1 while being supported in a horizontal posture.

The chucks 9 each include a lower surface support part 11 and a peripheral edge support part 13. The lower surface support part 11 contacts and supports a lower surface of the substrate W. The lower surface support part 11 is preferably constituted so as to have a small contact area to the lower surface of the substrate W. This enables reduction in the degree of mutual contamination. The lower surface support part 11 is mounted on the upper surface of the spin chuck 3 so as to be rotatable about a rotation center P2. The rotation center P2 extends in a vertical direction. The peripheral edge support part 13 is erected on an upper surface of the lower surface support part 11. The peripheral edge support part 13 is preferably formed so as to have a height above the upper surface of the lower surface support part 11 larger than a thickness of the substrate W. Such a configuration enables the peripheral edge of the substrate W to be stably held. The peripheral edge support part 13 is provided at a position away from the rotation center P2 toward an outer edge of the lower surface support part 11 in plan view. In other words, the peripheral edge support part 13 is eccentric with respect to the rotation center P2.

A rotation magnet 15 is mounted on the lower surface of the spin chuck 3 at a position corresponding to the rotation center P2. The rotation magnet 15 is connected to the lower surface support part 11. The rotation magnet 15 is provided so as to be rotatable about the rotation center P2. A chuck drive mechanism 17 is disposed below the rotation magnet 15.

The chuck drive mechanism 17 is disposed on a side closer to the rotation shaft 5 than the chucks 9. The chuck drive mechanism 17 includes, for example, an air cylinder 19 and a driving magnet 21. The driving magnet 21 has an annular shape in plan view. The air cylinder 19 is disposed in a posture such that an actuation shaft thereof is pointed in the vertical direction. The driving magnet 21 is attached to a tip end of the actuation shaft of the air cylinder 19. The chuck drive mechanism 17 is operated in accordance with a chuck operation command. When the chuck drive mechanism 17 is in an actuated state, the driving magnet 21 moves upward to approach the chucks 9. When the chuck drive mechanism 17 is in a non-actuated state, the driving magnet 21 moves downward to move away from the chucks 9.

The chucks 9 each include a bias mechanism (not illustrated). When the driving magnet 21 moves downward, the chuck 9 moves to a closed position. When the driving magnet 21 moves upward, the chuck 9 moves to an open position. In the closed position, the peripheral edge support part 13 rotates about the rotation center P2, and approaches toward the rotation center P1 to contact the peripheral edge of the substrate W. This enables the chucks 9 to hold the substrate W in the closed position. In the open position, the peripheral edge support part 13 rotates about the rotation center P2, and moves in a direction away from the rotation center P1. This enables the chucks 9 to load and unload the substrate W in the open position. Note that, when the driving magnet 21 moves downward in a state in which the substrate W is not placed, the chuck 9 moves to an origin position such that the peripheral edge support part 13 is shifted slightly inward of an outer diameter of the substrate W. In other words, the origin position of the chuck 9 is such that the peripheral edge support part 13 is located on a side closer to the rotation center P1 than the closed position.

An origin sensor Z1 is disposed near the rotation magnet 15 of the chuck 9. The origin sensor Z1 changes an output signal when the chuck 9 moves to the closed position or the origin position. For example, the origin sensor Z1 turns an output signal on when the chuck 9 moves to the closed position or the origin position.

A guard 23 is disposed around the spin chuck 3. The guard 23 surrounds the spin chuck 3 laterally. The guard 23 prevents a treatment liquid from scattering in surrounding areas. The guard 23 has a tubular shape. The guard 23 has an opening 23a formed in an upper part thereof. The opening 23a has an internal diameter larger than an outer contour of the spin chuck 3.

The guard 23 includes a guard movement mechanism 25. The guard movement mechanism 25 includes, for example, an air cylinder 27 and a locking piece 29. The guard movement mechanism 25 is disposed, for example, on a side of an outer periphery of the guard 23. The guard movement mechanism 25 may be disposed on a side of an inner periphery of the guard 23 as long as the guard movement mechanism 25 can move the guard 23 upward and downward. The air cylinder 27 is disposed in a posture such that an actuation shaft thereof is pointed in the vertical direction. The locking piece 29 is attached to a tip end of the actuation shaft of the air cylinder 27. The locking piece 29 is fixed to an outer peripheral surface of the guard 23. The guard movement mechanism 25 is not limited to such a configuration as long as the guard 23 can move upward and downward.

The guard movement mechanism 25 moves the guard 23 between an origin position of the guard 23 and a treatment position thereof in accordance with a guard operation command. The origin position is a position such that an upper end of the guard 23 is at a low level. The origin position is lower than the treatment position. The treatment position is higher than the origin position. In a state in which the guard 23 is located at the origin position, an upper edge of the guard 23 is at a lower level than the substrate W supported by the spin chuck 3. In a state in which the guard 23 is located at the treatment position, the upper edge of the guard 23 is at a higher level than the substrate W supported by the spin chuck 3. For example, an origin sensor Z2 is disposed on the side of the inner periphery of the guard 23. The origin sensor Z2 changes an output signal when the guard 23 moves to the origin position. For example, the origin sensor Z2 turns an output signal on when the guard 23 moves to the origin position.

The guard 23 includes a plurality of drain ports (not illustrated) on the side of the inner periphery thereof. As the guard 23, a plurality of guards 23 are preferably provided such that the guard movement mechanism 25 moves the guards 23 upward and downward to perform switching between the drain ports. In this case, as switching between the drain ports is performed in accordance with a treatment liquid, the guard movement mechanism 25 changes levels of the guards 23 accordingly.

A treatment liquid supply mechanism 31 is disposed on the side of the outer periphery of the guard 23. The treatment liquid supply mechanism 31 includes, for example, a nozzle 33 and a nozzle movement mechanism 35. In the present embodiment, the treatment liquid supply mechanism 31 includes, for example, two nozzles 33. In the following description, in a case where the two nozzles 33 need to be distinguished, a nozzle on the left side and a nozzle on the right side in Fig. 2 are referred to as a nozzle 33A and a nozzle 33B, respectively, as appropriate. The treatment liquid supply mechanism 31 may include one nozzle 33 or three or more nozzles 33. In the present embodiment, the two nozzles 33 have the same configuration.

The nozzle 33 includes an extension portion 33a, a hang-down portion 33b, and a distal end portion 33c. One end of the extension portion 33a of the nozzle 33 is attached to a base part 37. The extension portion 33a extends in a horizontal direction. The other end of the extension portion 33a is connected to the hang-down portion 33b. The hang-down portion 33b extends downward from the extension portion 33a in the vertical direction. The distal end portion 33c constitutes a lower end of the hang-down portion 33b. The distal end portion 33c ejects a treatment liquid through a lower surface thereof. That is, the nozzle 33 ejects a treatment liquid through the distal end portion 33c with respect to the substrate W supported by the spin chuck 3. Examples of the treatment liquid include a photoresist liquid, a spin-on-glass (SOG) liquid, a developer, a rinse liquid, deionized water, and a cleaning liquid.

The nozzle movement mechanism 35 includes, for example, a motor 39, a rotation shaft 41, and a position detection unit 43. The motor 39 is disposed in a vertical posture. The rotation shaft 41 is rotated about a rotation center P3 by the motor 39. The rotation shaft 41 is connected to the base part 37. The base part 37 is rotated by drive of the motor 39. The nozzle 33 swings about the rotation center P3 together with the base part 37. The position detection unit 43 detects a rotation position of the rotation shaft 41. The position detection unit 43 detects an angle of the rotation shaft 41 about the rotation center P3 in plan view. The position detection unit 43 outputs a pulse in accordance with the rotation position.

A standby cup 44 is disposed at a position laterally away from the guard 23 in plan view. The standby cup 44 is disposed, in plan view, on the opposite side from the base part 37 and on a side of the distal end portion 33c of the nozzle 33. The standby cup 44 is disposed at the origin position of the nozzle 33. The standby cup 44 prevents drying of the distal end portion 33c of the nozzle 33. The standby cup 44 is used for idle ejection of the nozzle 33. The nozzle movement mechanism 35 drives the motor 39 to swing the nozzle 33. The nozzle movement mechanism 35 moves the distal end portion 33c between the origin position of the nozzle 33, which is a position laterally away from the substrate W, and an ejection position thereof (ejection position above the substrate W), which is a position above the rotation center P1 of the spin chuck 3.

For example, an origin sensor Z3 is disposed on an outer periphery of the rotation shaft 41. The origin sensor Z3 changes an output signal when the nozzle 33 is located at the origin position. For example, the origin sensor Z3 turns an output signal on when the nozzle 33 moves to the origin position. Note that the origin sensor Z3 may be omitted for a simple configuration. In this case, a protrusion is provided on a part of the rotation shaft 41, and a protrusion is also provided on a stationary side of the rotation shaft 41. By rotation of the rotation shaft 41, these protrusions contact each other, the position detection unit 43 detects a position at which the rotation shaft 41 can rotate no further, and such a position is set as the origin position. Such a configuration may be employed. In such a case, a position where a pulse of the position detection unit 43 becomes unchanged may be handled as the origin position.

A fixed nozzle RN is disposed at a position laterally away from the guard 23 in plan view. The fixed nozzle RN is disposed, for example, on a line that connects the standby cup 44 and the rotation center P1 in plan view. The position of the fixed nozzle RN is fixed. The position is fixed in a height direction and a horizontal direction. The fixed nozzle RN has a distal end that is pointed toward the rotation center P1. The fixed nozzle RN supplies a treatment liquid. The treatment liquid is supplied from a treatment liquid supply unit SU to the fixed nozzle RN. Examples of the treatment liquid include deionized water and a cleaning liquid. The treatment liquid supply unit SU includes, for example, a control valve, a flow rate regulation valve, and a treatment liquid supply source (not illustrated). For example, when the treatment liquid is supplied from the treatment liquid supply unit SU to the fixed nozzle RN, the fixed nozzle RN ejects the treatment liquid while forming an arc-shaped trajectory. The treatment liquid ejected from the fixed nozzle RN is adjusted in flow rate and flow speed by a flow rate adjustment valve (not illustrated) so as to drop at or near an intersection of the upper surface of the substrate W and the rotation center P1.

A camera CM is mounted in one place of the casing CA. For example, in plan view, the camera CM is mounted at a predetermined placement position that is on a side on which the standby cup 44 of the nozzle 33 is disposed and that corresponds to a corner of the casing CA close to the guard movement mechanism 25. Note that the placement position of the camera CM may be any location as long as a component described later is within the field of view. A lens of the camera CM has a viewing angle such that the component described later is entirely within the field of view. That is, the camera CM is an image capture unit that captures an image of a component as a real image. The camera CM captures a static image. The camera CM can also capture a video image of a predetermined number of frames per unit time.

The substrate treatment apparatus 1 includes a control unit 45, an instruction unit 47, and a notification unit 49. Details of the control unit 45 will be described later. The instruction unit 47 is operated by an operator of the substrate treatment apparatus 1. The instruction unit 47 is, for example, a keyboard or a touch panel. The instruction unit 47 provides instructions on a component, a check timing, a tolerance, recipes, start of processing, and the like, which will be described later. When the control unit 45 determines the presence of an anomaly, the notification unit 49 notifies the operator of the anomaly. Examples of the notification unit 49 include an indicator, a lamp, and a speaker.

### <2. Configuration of Control System>

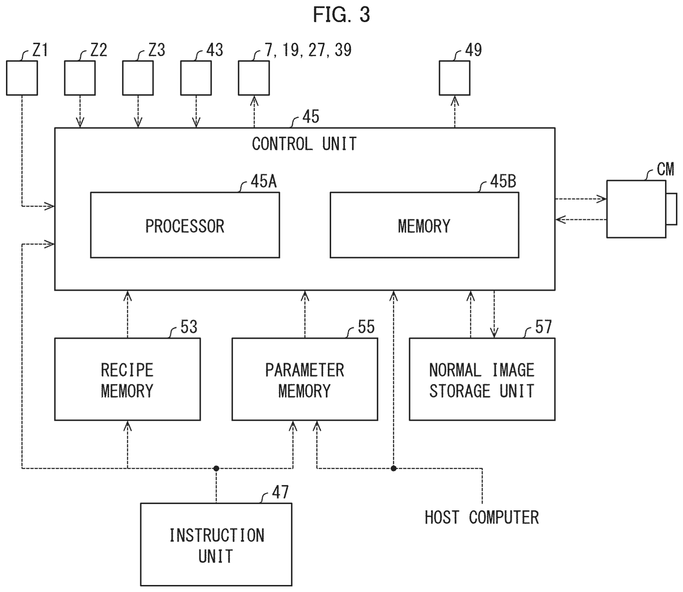

Here, reference is made to Fig. 3. Fig. 3 is a block diagram of the substrate treatment apparatus in accordance with Embodiment 1. As illustrated in Fig. 3, the substrate treatment apparatus 1 includes a recipe memory 53, a parameter memory 55, and a normal image storage unit 57, in addition to the members that have been described with reference to Figs. 1 and 2. These storage members may be, for example, a non-volatile memory such as a hard disk drive (HDD) or a solid state drive (SSD).

The control unit 45 performs centralized control of the substrate treatment apparatus 1. The control unit 45 includes, for example, a processor 45A and a memory 45B. The processor 45A may be referred to as a central processing unit (CPU). The memory 45B may be, for example, a volatile memory such as a random access memory (RAM). The processor 45A carries out various processes in conjunction with the memory 45B. The processor 45A carries out, for example, the following processes.

The processor 45A operates, for example, the motors 7 and 39, the air cylinders 19 and 27, the camera CM, and the treatment liquid supply unit SU, which have been described above. The processor 45A receives signals from the origin sensors Z1 to Z3 and the position detection unit 43. The processor 45A performs the operations in accordance with a recipe specified by the recipe memory 53. For example, after the operator has provided instructions on a recipe and the start of processing, the processor 45A outputs various types of operation commands on the basis of the recipe to operate the motor 7 and the like at a predetermined timing.

The recipe memory 53 is a recipe storage unit that stores various types of recipes in advance. The recipes specify various procedures for treating the substrate W. The recipes specify, for example, details of an operation of a component, an order of execution, and a timing of the execution. The recipes can be acquired from a host computer. Specific examples and details of the recipe will be described later. The operator can operate the instruction unit 47 to provide instructions on a desired recipe.

The parameter memory 55 stores a component, a check timing, a tolerance, and the like.

The component is one of constituent elements of the substrate treatment apparatus 1. In the present embodiment, the component is an element that is a target for anomaly detection (monitoring target component) among the constituent elements of the substrate treatment apparatus 1. The component may include a fluid such as a treatment liquid. The component may be, for example, the chuck 9, the guard 23, the nozzle 33, and the fixed nozzle RN. Further, the component may be, for example, a treatment liquid from the nozzle 33 or the fixed nozzle RN. The component may be one whose position moves over time due to execution of the recipe.

The check timing is a timing for checking an operational state of the component. The check timing is one time point on a time base of the recipe described later. The check timing is synchronized with the execution of the recipe. The check timing corresponds to one normal image described later. The check timing is specified during simulation described later, and a desired check timing can be specified from the instruction unit 47. The operator can set the component, the check timing, the tolerance, and the like as desired by operating the instruction unit 47. The operator can cause the instruction unit 47 to provide instructions on, for example, which element is to be set as the component targeted for anomaly detection, which timing is to be set as the check timing, and acceptable levels of a timing error and a positional error.

The check timing is, for example, a predetermined timing during movement of the nozzle 33 from the origin position to the ejection position by the nozzle operation command and a predetermined timing during ejection of the treatment liquid from the nozzle 33 or the fixed nozzle RN.

The tolerance indicates a degree of acceptance of deviation in a real image, at a check timing, from a position at which the component should be located during a normal operation (normal image which will be described later). The tolerance is, for example, a degree that indicates an acceptable level of deviation of the component from a position or an angle intended by design. For example, the tolerance indicates a range of the deviation of the component at the check timing that allows treatment of the substrate W even if the component deviates from the position or the angle intended by design at the check timing with respect to the treatment of the substrate W as a reference.

The processor 45A outputs an image capture command to the camera CM at the check timing to cause the camera CM to capture a real image while executing the recipe in accordance with the check timing in the parameter memory 55, and compares between the real image and a normal image described later.

The normal image storage unit 57 stores a normal image. The normal image is, for example, a static image. The normal image is stored, for each recipe stored in the recipe memory 53, in association with the check timing. The normal image is an image based on three-dimensional design information pertaining to assembly and operation of the substrate treatment apparatus 1.

The normal image is an image obtained, in a view from the same placement position as that of the camera CM, under a condition where the processor 45A has simulated in advance a state in which a normal operation is carried out in accordance with the recipe on the basis of the three-dimensional design information pertaining to the substrate treatment apparatus 1. The normal image is an image obtained in association with a check timing on a time base of the recipe. A plurality of check timings may be set at the simulation. In other words, a plurality of normal images can be provided for one recipe.

The processor 45A can simulate a state in which the substrate treatment apparatus 1 operates normally in accordance with the recipe by causing the substrate treatment apparatus 1 to operate in accordance with the recipe before performing an actual treatment on the substrate W. The processor 45A operates the components at a predetermined timing and in a predetermined order in accordance with the specification of the recipe. In other words, the processor 45A can operate the substrate treatment apparatus 1 assembled in conformity with the three-dimensional design information, normally in accordance with the recipe virtually.

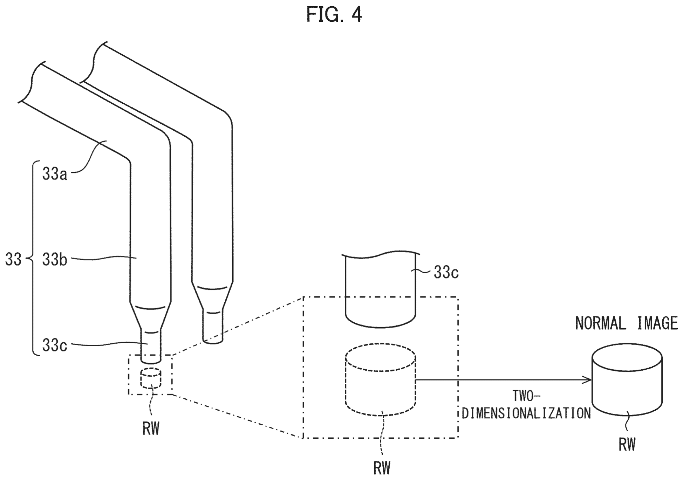

Before performing an actual treatment on the substrate W, the processor 45A performs the above-described simulation to generate a normal image for each check timing, and stores the normal image in the normal image storage unit 57. Fig. 4 is a view schematically illustrating a process of generating the normal image.

Specifically, the processor 45A sets a monitoring region three-dimensionally on the basis of the three-dimensional design information of the substrate treatment apparatus 1 (a process "a"). The monitoring region is a region in which a component that is a target for anomaly detection is monitored. For example, the monitoring region may be set so as to include at least a part of the component, or may be set outside the component (for example, at a position near the component). Further, as described above, the component may include a treatment liquid. Thus, the monitoring region may be set in a part of a path through which the treatment liquid passes, so that whether or not the treatment liquid is ejected can be monitored.

The three-dimensional design information pertaining to the substrate treatment apparatus 1 is three-dimensional design information pertaining to sections (components) in the substrate treatment apparatus 1. The design information pertaining to the sections is design information pertaining to the components that constitute the substrate treatment apparatus 1 and a substrate W to be treated. The design information is, for example, data of three-dimensional computer aided design (3D CAD). The design information may include physical property information pertaining to a treatment liquid and various materials which are used for treatment.

The 3D CAD data is represented by, for example, three orthogonal coordinate axes. When a component is disposed in a three-dimensional space, the 3D CAD data is represented by positional information about a position and an angle. A host computer (not illustrated) stores three-dimensional design information as the 3D CAD data pertaining to all of the components and materials of the substrate treatment apparatus 1. The processor 45A receives, from the host computer, this 3D CAD data, that is, the three-dimensional design information pertaining to the substrate treatment apparatus 1, and generates a normal image.

As illustrated in Fig. 4, the processor 45A generates, on the basis of the three-dimensional design information pertaining to the substrate treatment apparatus 1, a three-dimensional image (three-dimensional image that serves as a source for a normal image) including a component that is a target for anomaly detection. The processor 45A generates a three-dimensional image at one check timing when a state in which a normal operation is carried out in accordance with a recipe is simulated, the three-dimensional image corresponding to a real image captured from a viewpoint of the placement position of the camera CM. The processor 45A sets a monitoring region in this three-dimensional image. That is, the processor 45A sets a three-dimensional monitoring region in the view from the placement position of the camera CM.

In the example of Fig. 4, the component that is a target for anomaly detection may be the nozzle 33 or may be a treatment liquid ejected from the nozzle 33. In the example of Fig. 4, a region in front of the distal end portion 33c of the nozzle 33 in an ejection direction of the treatment liquid is set as a monitoring region RW at one check timing.

Further, when setting the monitoring region three-dimensionally, the processor 45A adjusts the position and the like of the monitoring region by comparing the generated three-dimensional image with a real image captured by the camera CM.

Specifically, before performing an actual treatment on the substrate W, the processor 45A displays the three-dimensionally set monitoring region in a superimposed manner on a real image that has been captured as an adjustment image (reference image) by the camera CM (part of a process "e"). The processor 45A causes an article that is a target for anomaly detection (the nozzle 33 in the example of Fig. 4) to move to a position at one check timing when the three-dimensional image has been generated, and outputs, to the camera CM, an image capture command to capture a real image of the article at that position. The processor 45A acquires, as the adjustment image, the real image, which has been captured on the basis of this image capture command, of the article that is identical (or can be regarded as being identical) to an article captured in the three-dimensional image. The processor 45A displays the monitoring region set in the three-dimensional image in a superimposed manner on the adjustment image by superimposing the acquired adjustment image and the generated three-dimensional image.

The processor 45A acquires an adjustment result in which at least one selected from the group consisting of the position of the monitoring region, the size thereof, and the posture thereof has been adjusted by the user on the basis of the superimposed display (part of the process "e"). Then, the processor 45A sets, on the basis of the adjustment result, at least one selected from the group consisting of the position of the monitoring region, the size thereof, and the posture thereof (a process "f").

Specifically, the processor 45A outputs, to the notification unit 49, a notification command to provide a notification of the adjustment image on which the monitoring region is displayed in a superimposed manner. The user determines whether the position of the monitoring region, the size thereof, and the posture thereof are appropriate by visually recognizing the adjustment image on which the monitoring region is displayed in a superimposed manner, which adjustment image is notified of by the notification unit 49. In a case where the user has determined that at least one selected from the group consisting of the position of the monitoring region, the size thereof, and the posture thereof is not appropriate, the user makes an adjustment on at least one selected from the group consisting of the position of the monitoring region, the size thereof, and the position thereof in the adjustment image via the instruction unit 47. The processor 45A can adjust the position of the monitoring region, the size thereof, and the posture thereof to an appropriate position, an appropriate size, and an appropriate posture by reflecting the acquired adjustment result in the adjustment image.

In a case where the processor 45A has acquired an input indicating that the position of the monitoring region, the size thereof, and the posture thereof are appropriate via the instruction unit 47, the processor 45A adjusts at least one selected from the group consisting of the position of the monitoring region, the size thereof, and the posture thereof in the three-dimensional image on the basis of the adjustment result of the monitoring region in the adjustment image. This enables the processor 45A to three-dimensionally set a monitoring region that is in a state in which at least one selected from the group consisting of the position of the monitoring region, the size thereof, and the posture thereof is adjusted.

In this way, the processor 45A performs adjustment of the monitoring region using the adjustment image. Thus, it is possible to set the monitoring region three-dimensionally while taking into account a real image captured during working in which the substrate W is actually treated in accordance with the recipe. Further, in setting the monitoring region three-dimensionally, the user can finely adjust the position and the like of the monitoring region.

As described above, the processor 45A sets a three-dimensional monitoring region in a view from the placement position of the camera CM at one check timing during a normal operation carried out in accordance with the recipe. Further, the processor 45A can three-dimensionally identify the position of the article, the size thereof, and the posture thereof at each check timing on the recipe in the simulation, on the basis of the three-dimensional design information pertaining to the substrate treatment apparatus 1, the recipe, and the check timing. Thus, by three-dimensionally setting the monitoring region at one check timing, the processor 45A can calculate the position of the monitoring region, the size thereof, and the posture thereof at another check timing in accordance with the position of the article, the size thereof, and the posture thereof at the another check timing.

Thus, even when the size and posture of the article have changed due to a change in the position of the article during a normal operation carried out in accordance with the recipe, it is possible to follow changes in the position, size, and posture of the article and change the position, size, and posture of the monitoring region. Therefore, the processor 45A can three-dimensionally set the monitoring region at each of a plurality of check timings only by three-dimensionally setting the monitoring region at one check timing.

For example, in a case where the component is located at a position far from the camera CM, the processor 45A can set a smaller monitoring region in accordance with that position. In a case where the component is located at a position close to the camera CM, the processor 45A can set a larger monitoring region in accordance with that position. Further, for example, in a case where the monitoring region is inclined obliquely, the processor 45A can set a monitoring region that has a size and a posture (shape) corresponding to an angle formed between the camera CM and the component.

That is, the processor 45A may set a monitoring region at each check timing with respect to a three-dimensional image obtained at each check timing when the above-described simulation has been performed, the three-dimensional image corresponding to a real image captured from a viewpoint of the placement position of the camera CM.

Here, a case where a monitoring region is set two-dimensionally is considered. At two check timings, the distance between the component and the camera CM may be different, and in this case, at least one selected from the group consisting of the position of the component, the size thereof, and the posture thereof is different. Thus, due to the influence of a perspective between this component and the camera CM, the position, size, and posture of the monitoring region also differ at a plurality of check timings. Therefore, in a case where the monitoring region is set two-dimensionally, an adjustment image for each position of the component is captured, and the monitoring region is set for each adjustment image.

In contrast, the processor 45A can three-dimensionally set the monitoring region at each check timing as described above. Thus, the processor 45A does not need to acquire an adjustment image for each position of the component in order to set the monitoring region for each check timing. Thus, the processor 45A of the present embodiment can set a monitoring region by efficient processing. Further, since the monitoring region can be set three-dimensionally, the monitoring region can be optimized in association with the position of the component.

The processor 45A generates a normal image for each of a plurality of timings during a normal operation carried out in accordance with a recipe by two-dimensionalizing the three-dimensionally set monitoring region in a view from the placement position of the camera CM (a process "b"). The plurality of timings may be the above-described plurality of check timings.

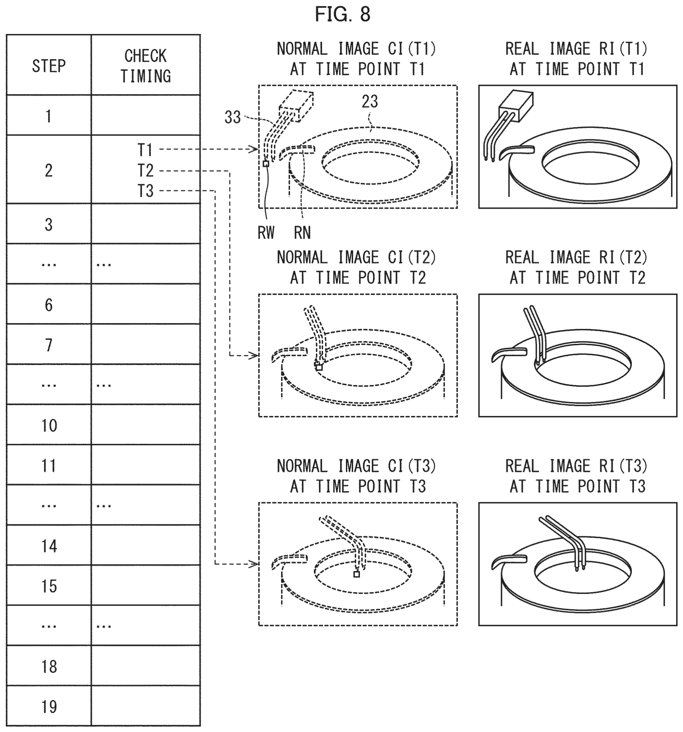

In the example of Fig. 4, the processor 45A generates a normal image by two-dimensionalizing the monitoring region RW in front of the distal end portion 33c of the nozzle 33, which has been set three-dimensionally at one check timing. As described above, the normal image is an image obtained at each check timing when a state in which a normal operation is carried out in accordance with a recipe is simulated, and only needs to be an image including a monitoring region, as illustrated in Fig. 8.

In this way, the processor 45A generates a normal image by two-dimensionalizing the three-dimensionally set monitoring region. Thus, it is possible to compare the normal image with a real image at each check timing when a predetermined treatment is carried out.

Before performing an actual treatment on the substrate W, the processor 45A stores the generated normal image in the normal image storage unit 57 (a process "c"). The processor 45A stores, in the normal image storage unit 57, each generated normal image in association with a recipe and a check timing.

During working in which the substrate W is actually treated in accordance with the recipe, the processor 45A detects an anomaly on the basis of a difference between the normal image and the real image captured by the camera CM, the normal image and the real image being synchronized with the operation carried out in accordance with the recipe (a process "d"). This anomaly detection process is performed using a normal image obtained by two-dimensionalizing a three-dimensionally set monitoring region. That is, the anomaly detection process is performed using a monitoring region which has been set by efficient processing. Thus, the processor 45A can efficiently monitor the presence or absence of an anomaly related to an operational state of a component that is a target for anomaly detection (monitoring target article).

The processor 45A may carry out the following process as a process to be carried out before the anomaly detection process. For example, the processor 45A performs image processing on a real image and extracts a real image including a two-dimensional shape of the component. The processor 45A performs, for example, contour extraction on all of components in the real image. The contour referred to herein contains not only an outer contour but also an edge portion located inside the outer contour.

Thereafter, the processor 45A performs a process of comparison between the normal image and the real image. The normal image is an image given from the normal image storage unit 57. The real image is a real image on which the processor 45A has performed image processing. The normal image and the real image are synchronized with the execution of a recipe that is executed by the processor 45A. That is, the normal image is generated at each check timing in the recipe when the recipe is executed by simulation. The real image is an image that, when the recipe is executed, the processor 45A causes the camera CM to capture in accordance with a check timing which is from the parameter memory 55 and which is associated with the recipe. The processor 45A performs comparison between the normal image and the real image to identify components in the normal image and components in the real image. This identification establishes a state that enables identical components to be compared with each other among a plurality of components present in the normal image and a plurality of components present in the real image.

Thus, in a case where a monitoring region is set in a component, the processor 45A can compare components in which the monitoring region is set. Further, in a case where the monitoring region is set in a region different from the component (for example, in a case where the monitoring region is a region in front of the distal end portion 33c of the nozzle 33), the processor 45A can identify, in a real image, a region corresponding to the monitoring region in the normal image by identification of the identical components. Thus, even in this case, the processor 45A can perform a comparison between the monitoring region in the normal image and a region corresponding to the monitoring region in the real image. Thus, the processor 45A can detect an anomaly on the basis of a difference between the normal image and the real image captured by the camera CM.

For example, in a case where the processor 45A sets the monitoring region three-dimensionally on the basis of the three-dimensional design information pertaining to the nozzle 33, the processor 45A detects an anomaly related to the movement of the nozzle 33. In this case, the processor 45A sets, for example, a region including at least a part of the nozzle 33 or a region ("RW" in Fig. 4) in front of the distal end portion 33c as the monitoring region. As described later, since the position of the nozzle 33 varies in accordance with the recipe, the processor 45A can detect an anomaly related to the movement of the nozzle 33 by comparison between the normal image and the real image.

Further, in the case where the processor 45A sets the region in front of the distal end portion 33c as the monitoring region, there are cases where an image of the treatment liquid is included in the monitoring region in the normal image and cases where the image of the treatment liquid is not included therein, depending on the recipe. Thus, the processor 45A may perform detection of an anomaly related to the ejection operation of the treatment liquid by comparing the presence or absence of the treatment liquid between the monitoring region and a region corresponding to the monitoring region in the real image in accordance with the recipe.

In detecting an anomaly, the processor 45A may take into account a tolerance in the parameter memory 55. In other words, even when the positions and the like of the components in the normal image and in the real image do not exactly match, an anomaly is not detected as long as such a mismatch is within the tolerance.

The processor 45A causes the notification unit 49 to perform a notification operation in accordance with an anomaly detection result. Specifically, the processor 45A causes the notification unit 49 to perform a notification operation only in a case where an anomaly has been detected. The notification unit 49 may provide notification of, together with the occurrence of an anomaly, for example, a component in which the occurrence of the anomaly has been determined and a degree of difference.

### <3. Details of Recipe>

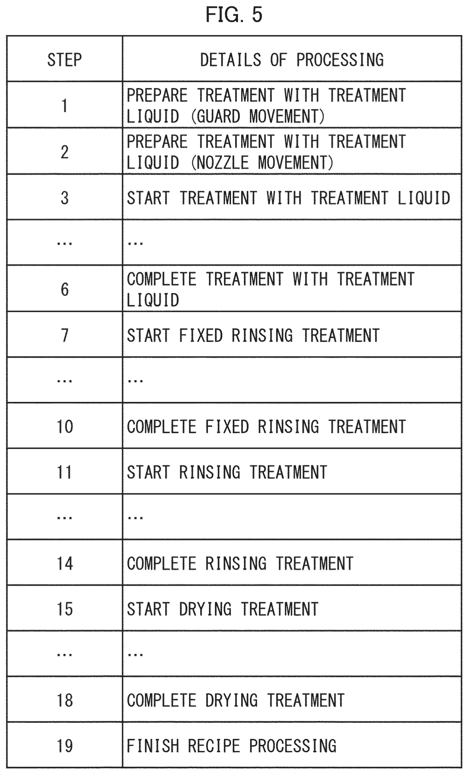

Here, a recipe will be described with reference to Fig. 5. Note that Fig. 5 illustrates an example of a recipe and is a schematic view illustrating details of the recipe.

In this example, the recipe is constituted by a step and details of processing. The steps specify an execution order. The details of processing specify what kind of operation is to be performed. Specifically, the details of processing specify details of an operation of a component. In detail, the recipe is divided into recipe steps that specify more detailed operations. Note, however, that description of the recipe steps is to be omitted for easy understanding of the invention. In addition, detailed treatments to be performed in an actual treatment are omitted.

This recipe includes, for example, the following content.

In a first step, a preparation for a treatment with a treatment liquid (guard movement) is performed to move the guard 23 to the treatment position. In a second step, a preparation for the treatment with a treatment liquid (nozzle movement) is performed to move the nozzle 33 to the ejection position. In a third step, start of the treatment with a treatment liquid is performed to start the treatment of a substrate W with a treatment liquid. In a sixth step, completion of the treatment with a treatment liquid is performed to carry out processing for completion of the treatment with a treatment liquid. In a seventh step, start of a fixed rinsing treatment is performed to start a treatment with use of the fixed nozzle RN. In a tenth step, processing for completion of the fixed rinsing treatment is performed to complete the treatment with use of the fixed nozzle RN. In an eleventh step, start of a rinsing treatment is performed to start a treatment with a rinsing liquid from the nozzle 33. In a fourteenth step, completion of the rinsing treatment is performed to carry out processing for completion of the treatment with the rinsing liquid from the nozzle 33 (including movement of the nozzle 33). In a fifteenth step, start of a drying treatment is performed to start processing for increasing the number of rotations of the motor 7. In an eighteenth step, completion of the drying treatment is performed to stop the motor 7. In a nineteenth step, finishing of recipe processing is performed to carry out processing related to unloading of the substrate W.

### <4. Specific Example of Normal Image Generation Process>

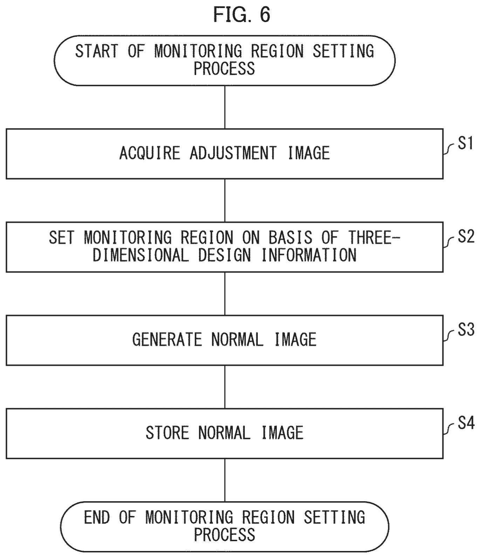

Next, an example of a normal image generation process including a monitoring region setting process will be described with reference to Fig. 6. Fig. 6 is a flowchart illustrating an example of a flow of the normal image generation process in the substrate treatment apparatus in accordance with Embodiment 1. This process is a process carried out before an actual treatment is performed on the substrate W, and is an example of a substrate treatment method. When the recipe memory 53 includes a plurality of recipes, the following processes may be carried out for each recipe.

First, the processor 45A acquires an adjustment image (S1). The adjustment image is used to adjust at least one selected from the group consisting of the position of the monitoring region, the size thereof, and the posture thereof, as described above. Thus, the processor 45A causes the camera CM to capture a real image including an article that is a target for anomaly detection at one check timing on a recipe, and acquires the real image as the adjustment image.

Next, the processor 45A sets a monitoring region three-dimensionally on the basis of the three-dimensional design information pertaining to the substrate treatment apparatus 1 (S2). The processor 45A sets the monitoring region in a three-dimensional image at one check timing. The processor 45A may display the monitoring region in a superimposed manner on the adjustment image and set, on the basis of an adjustment result obtained from a user based on the superimposed display, at least one selected from the group consisting of the position of the monitoring region, the size thereof, and the posture thereof. Thereafter, using the three-dimensional monitoring region which has been set at the one check timing, the processor 45A sets a three-dimensional monitoring region at another check timing.

Next, the processor 45A generates a normal image for each of a plurality of timings by two-dimensionalizing the monitoring region in a view from the placement position of the camera CM (S3). Then, the processor 45A stores the generated normal image in the normal image storage unit 57 (S4).

### <5. Specific Example of Anomaly Detection Process>

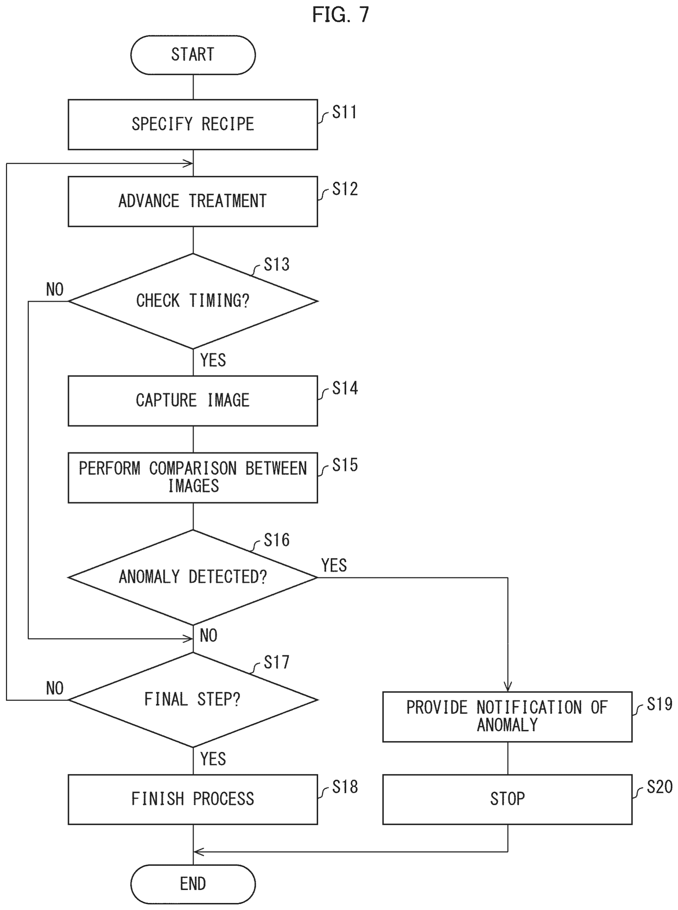

Next, a specific example of the anomaly detection process will be described with reference to Figs. 7 and 8. Note that Fig. 7 is a flowchart illustrating an example of a flow of the anomaly detection process in the substrate treatment apparatus in accordance with Embodiment 1. Fig. 8 is a schematic view for describing a comparison between a normal image and a real image during working of the apparatus. This process is a process carried out during working in which the substrate W is actually treated in accordance with the recipe, and is an example of the substrate treatment method.

First, the operator operates the instruction unit 47 to specify a desired recipe (S11). The operator operates the instruction unit 47 as necessary to specify a desired check timing among a plurality of check timings that are associated with the specified recipe. In a case where such specification is not performed, all of the associated check timings may be specified. Note that, in the present embodiment, it is assumed that the recipe illustrated in Fig. 5 is specified. In addition, it is assumed that check timings T1 to T3 illustrated in Fig. 8 are all specified. Here, it is assumed that a substrate W to be treated is already held by the chucks 9.

Next, the processor 45A operates the components in accordance with the recipe to advance the treatment (S12). For example, the first step is performed in accordance with the recipe illustrated in Fig. 5. Specifically, the processor 45A operates the guard movement mechanism 25. Then, the processor 45A moves the guard 23 from the origin position to the treatment position.

Next, the processor 45A ascertains whether or not it is a check timing, and the process is branched (S13). Specifically, the processor 45A refers to the parameter memory 55 to ascertain whether or not there is a check timing corresponding to the step in the recipe. As illustrated in Fig. 8, since a check timing is not set in the first step in the recipe, the process is branched to step S17.

In step S17, the processor 45A branches the process according to whether or not it is the final step in the recipe. Here, since only the first step has been performed, the process returns to step S12.

In step S12, the processor 45A performs the next second step in accordance with the recipe. Specifically, the processor 45A performs preparation of a treatment liquid. The processor 45A operates the nozzle movement mechanism 35 to move the nozzle 33 from the origin position to the ejection position.

Next, in step S13, the processor 45A ascertains whether or not it is a check timing, and the process is branched. Here, as illustrated in Fig. 8, since the check timings T1 to T3 are set, the process proceeds to step S14.

In step S14, the processor 45A operates the camera CM to capture an image at the check timing T1. This image is a real image RI(T1) at a time point T1.

Next, the processor 45A establishes a state that enables identical components to be compared with each other in a normal image CI(T1), which corresponds to the check timing T1 in the normal image storage unit 57, and the real image RI(T1) (S15).

Next, the processor 45A performs a comparison between the normal image CI(T1) and the real image RI(T1) which are synchronized with the recipe, and detects an anomaly on the basis of a difference between the images. The processor 45A performs a comparison between a monitoring region in the normal image CI(T1) and a region corresponding to the monitoring region in the real image RI(T1), and detects an anomaly on the basis of a difference between the regions. At this time, a tolerance in the parameter memory 55 is preferably taken into account. This enables the processor 45A to prevent erroneous anomaly detection caused by a processing error and an assembly error.

As in this second step, in a case where a plurality of check timings are set in the same step, steps S13 to S16 are repeated unless it is determined in step S16 that there is an anomaly. In this example, the three check timings T1 to T3 are set in the second step. Thus, the processor 45A repeatedly performs steps S14 to S16 at all of these check timings T1 to T3 unless an anomaly is detected. Here, under the assumption that no anomaly has been detected, the process proceeds to step S17.

In step S17, the processor 45A branches the process according to whether or not it is the final step in the recipe. Here, since it is in a state in which the second step has been performed, the process returns to step S12.

In step S12, the processor 45A further advances the process in accordance with the recipe. Thereafter, it is assumed that the processor 45A has repeatedly performed steps S12 to S17 in the third step to the eighteenth step, and the process has advanced to the nineteenth step, which is the final step. Since the nineteenth step is the final step in this recipe, the process is branched to step S18, and the processor 45A finishes the process. This ends the treatment of the substrate W based on this recipe.

Here, a case where the processor 45A has detected an anomaly in the above-described step S16 will be described. In this case, the process proceeds to step S19. In step S19, in a case where the processor 45A has detected an anomaly, the processor 45A causes the notification unit 49 to perform a notification operation. Further, the processor 45A stops the process (S20). This makes it possible to prevent improper treatment from being continuously performed on the substrate W by the substrate treatment apparatus 1.

Thus, during working in which the substrate W is actually treated in accordance with the recipe, the processor 45A detects an anomaly on the basis of a difference between the normal image CI and the real image RI that are synchronized with the operation carried out in accordance with the recipe. The normal image CI is an image stored in advance, in a view from the placement position of the camera CM, under a condition where a state in which a normal operation is carried out in accordance with the recipe has been simulated in advance on the basis of the three-dimensional design information. Therefore, since the image capture conditions can be made identical for all apparatuses, it is possible to avoid adverse effects caused by different image capture conditions. In addition, it is possible to prevent the normal image CI to be compared from deviation from the real image RI since the normal image CI and the real image RI are synchronized with the operation of the recipe. Therefore, it is possible to detect an anomaly accurately during working.

Further, the processor 45A sets a monitoring region three-dimensionally on the basis of the three-dimensional design information, and, for each of a plurality of timings during a normal operation carried out in accordance with the recipe, generates a normal image obtained by two-dimensionalizing the monitoring region in a view from the placement position. Thus, as described above, the processor 45A does not need to acquire an adjustment image for each position of the component, unlike the case where a monitoring region is set two-dimensionally. Thus, it is possible to generate the normal image by efficiently setting the monitoring region. Further, the processor 45A performs the anomaly detection process with use of a normal image obtained by two-dimensionalizing the efficiently set three-dimensional monitoring region. Thus, the processor 45A can efficiently monitor the presence or absence of an anomaly related to an operational state of the anomaly detection target.

### <6. Modification Example>

As an aspect of the present disclosure, the present disclosure is not limited to the embodiment described above and may be modified as follows.
(1) In the embodiment described above, the normal image and the real image are each a static image. However, the present disclosure is not limited to this, and the normal image and the real image may be each a video image. These video images may have the same frame rate, and the check timing described above may be set for each frame. This makes it possible to easily detect an anomaly and the like that have occurred between a source of movement and a destination thereof. Moreover, it is possible to increase the number of target locations for anomaly detection.
(2) In the embodiment described above, the normal image is simply an image based on three-dimensional design information. In the present disclosure, for example, reflection and shading caused by a surface shape of each component, reflection and fogging caused by a positional relationship in the casing CA and an environment therein, and the like may be reflected in the normal image. This makes it possible to prevent erroneous determination caused by a shape, an environment, and the like.
(3) In the embodiment described above, the substrate treatment apparatus 1 includes one camera CM. However, the present disclosure does not exclude the inclusion of a plurality of cameras CM. For example, the substrate treatment apparatus 1 may include a plurality of cameras CM, such as a camera CM dedicated to the nozzle 33 and a camera CM dedicated to the chuck 9. This makes it possible to improve the accuracy in detecting an anomaly, for example, especially in the case of a small component such as the chuck 9. In this case, as the normal image, a real image captured by each camera CM may be brought into correspondence with the normal image from a viewpoint of each camera CM.
(4) In the embodiment described above, anomalies in the movement of the nozzle 33 and the ejection of the treatment liquid from the nozzle 33 can be detected. However, the anomaly detection by the processor 45A of the present disclosure is not limited to the anomaly detection in these operations. For example, the processor 45A may detect anomalies in the movement of the guard 23, the ejection of the treatment liquid from the fixed nozzle RN, and the operation of the chuck 9. Further, the processor 45A may detect an anomaly in the ejection of the treatment liquid from each of the plurality of nozzles 33. The anomaly detection target may be a component that carries out an operation in accordance with a recipe, in particular.
(5) In the embodiment described above, one monitoring region is set for one normal image. However, the present disclosure is not limited to this, and a plurality of monitoring regions may be set for one normal image. This makes it possible to perform anomaly detection on a plurality of components.
(6) In the above-described embodiment, the substrate treatment apparatus 1, which treats the substrate W with a treatment liquid, has been described as an example. However, the present disclosure is not limited to this, and the present disclosure is also applicable to, for example, an apparatus that heat-treats the substrate W, an apparatus that transports the substrate W, and an apparatus that exposes the substrate W. Further, the present disclosure is not limited to a single-substrate treatment apparatus that treats the substrate W on a one-by-one basis such as the apparatus as described in the embodiment. That is, the present disclosure can be applied even to a batch-type apparatus that treats a plurality of substrates simultaneously.

### Embodiment 2

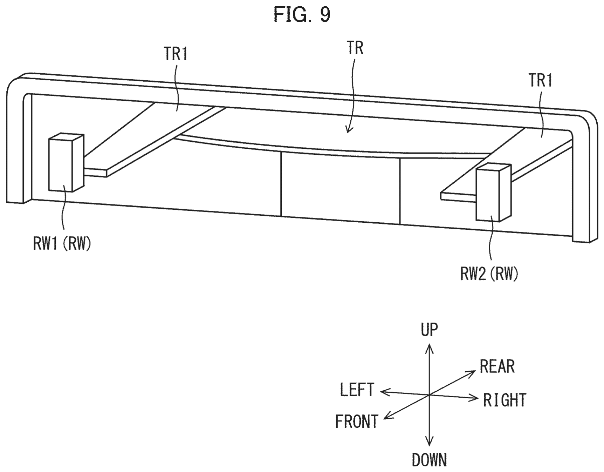

In Embodiment 2, a case where an anomaly detection target is a transport robot will be described. Fig. 9 is a perspective view illustrating an example of a transport robot in accordance with Embodiment 2.

The transport robot TR is a robot that transports a substrate W. For example, the transport robot TR transports (loads) the substrate W to be treated from a position of the substrate W before the treatment to the spin chuck 3. In the recipe described above, processing for loading the substrate W may be included before the first step (preparation for a treatment with a treatment liquid). Further, the transport robot TR transports (unloads) the substrate W after the treatment from the spin chuck 3 to another position. In the recipe described above, the nineteenth step (finishing of recipe processing) includes processing for unloading the substrate W. Further, at least one check timing is set during the processing for loading the substrate W, and at least one check timing is set during the processing for unloading the substrate W.

In the present embodiment, an operation of the transport robot TR is controlled by the control unit 45. Further, in the present embodiment, the transport robot TR is one of the constituent components of the substrate treatment apparatus 1. In both a case where the transport robot TR is provided in the substrate treatment apparatus 1 and a case where the transport robot TR functions as a device differing from the substrate treatment apparatus 1, the transport robot TR is a constituent component of the substrate treatment apparatus 1 in the sense that the transport robot TR transports the substrate W in the substrate treatment apparatus 1. That is, the constituent component of the substrate treatment apparatus 1 may be a component that is provided in the substrate treatment apparatus 1 or may be a component that functions as an apparatus differing from the substrate treatment apparatus 1, as long as the component performs an operation in the substrate treatment apparatus 1.

As illustrated in Fig. 9, the transport robot TR includes a robot hand TR1. The robot hand TR1 functions as a grip unit that grips the substrate W. The robot hand TR1 of the present embodiment includes a pair of holding parts that hold the substrate W. The robot hand TR1 is movable in the front-rear direction illustrated in Fig. 9. In Fig. 9, a spin chuck 3 is located on the near side of the paper sheet of Fig. 9 (in a direction in which the holding parts extend), and the side on which the spin chuck 3 is located is referred to as front of the holding parts. In Fig. 9, the front-rear direction, the up-down direction, and the left-right direction are defined as illustrated.

The processor 45A sets regions in front of the respective holding parts of the robot hand TR1 as monitoring regions RW1 and RW2. As illustrated in Fig. 9, the processor 45A sets, as the monitoring regions RW1 and RW2, spaces each having respective widths in the front-rear direction, the up-down direction, and the left-right direction. The size and shape of the monitoring regions RW1 and RW2 may be set such that an anomaly related to the operation of the robot hand TR1 can be detected accurately.

By the method described in Embodiment 1, the processor 45A sets the monitoring regions RW1 and RW2 three-dimensionally for all of the check timings when the robot hand TR1 moves. For example, the processor 45A sets the monitoring regions RW1 and RW2 in 3D CAD data (e.g., three-dimensional image) of the robot hand TR1 at each check timing. Then, the processor 45A generates normal images by two-dimensionalizing the set monitoring regions RW1 and RW2. The processor 45A stores the normal images in the normal image storage unit 57 in association with each check timing.

Setting the monitoring regions RW1 and RW2 in this manner enables the processor 45A to determine the appropriateness of a clearance of the robot hand TR1 on the basis of images in the monitoring regions RW1 and RW2 that move in conjunction with the operation of the robot hand TR1. This clearance may indicate a gap between the robot hand TR1 and other component.

During the transport of the substrate W when an actual treatment is to be performed on the substrate W, the processor 45A performs comparison between images included in the monitoring regions RW1 and RW2 of the normal images and regions corresponding to the monitoring regions RW1 and RW2 in a real image captured during the transport. In a case where a difference between these images is observed, the processor 45A may determine that the clearance is not appropriate, that is, that the robot hand TR1 is too close to other component. The processor 45A may detect this state as an anomaly related to the operation of the robot hand TR1.

### Embodiment 3

A substrate treatment system including a plurality of substrate treatment apparatuses 1 may be realized. The substrate treatment system includes, for example, a plurality of towers in which a plurality of stages of the substrate treatment apparatus 1 are provided in a height direction. In the substrate treatment system, the transport robot TR described above is disposed between the plurality of towers. The transport robot TR is configured so as to be able to move upward and downward in the height direction. The transport robot TR is configured so as to be able to advance and withdraw the robot hand TR1 to and from the substrate treatment apparatus 1. The transport robot TR delivers and receives the substrate W between the substrate treatment apparatuses 1.

In addition, the substrate treatment system may include a system control unit that performs centralized control of the substrate treatment apparatuses 1 and the transport robot TR.

### [Software Implementation Example]

The functions of the substrate treatment apparatus 1 (hereinafter referred to as "apparatus") can be realized by a program for causing a computer to function as the apparatus, the program causing the computer to function as control blocks of the apparatus (in particular, control blocks corresponding to the processes carried out by the control unit 45).

In this case, the above-described apparatus includes, as hardware for executing the program, a computer which includes at least one control device (e.g., processor) and at least one storage device (e.g., memory). By the control device and the storage device executing the program, the functions described in the foregoing embodiments are realized.

The program may be stored in one or more non-transitory computer-readable storage media. These storage media may or may not be provided in the above-described apparatus. In the latter case, the program can be supplied to or made available to the above-described apparatus via any transmission medium such as a wired transmission medium or a wireless transmission medium.

Further, some or all of functions of the control blocks can be realized by a logic circuit. For example, the present disclosure encompasses, in its scope, an integrated circuit in which a logic circuit that functions as each of the control blocks is formed. As another alternative, for example, it is possible to realize the functions of the control blocks by a quantum computer.

Further, each of the processes which are described in the foregoing embodiments may be carried out by artificial intelligence (AI). In this case, the AI may be operated by the control device, or alternatively operated by another device (e.g., an edge computer, a cloud server, or the like).

### [Summary]

A substrate treatment apparatus in accordance with a first aspect of the present disclosure is a substrate treatment apparatus configured to perform a predetermined treatment on a substrate, the apparatus including: a recipe storage unit configured to store a recipe that specifies details of an operation of a constituent component of the substrate treatment apparatus and an order of execution, in order to perform the predetermined treatment; an image capture unit provided at a predetermined placement position and configured to capture an image of the component as a real image; a normal image storage unit; a processor; and a memory, the processor being configured to carry out, in conjunction with the memory, the following processes (a) to (d):
(a) setting a monitoring region three-dimensionally on the basis of three-dimensional design information pertaining to the substrate treatment apparatus;
(b) for each of a plurality of timings during a normal operation carried out in accordance with the recipe, generating a normal image by two-dimensionalizing the monitoring region in a view from the placement position;
(c) before performing an actual treatment on the substrate, storing the normal image in the normal image storage unit; and
(d) during working in which the substrate is actually treated in accordance with the recipe, detecting an anomaly on the basis of a difference between the normal image and the real image captured by the image capture unit, the normal image and the real image being synchronized with an operation carried out in accordance with the recipe.

In a second aspect of the present disclosure, the substrate treatment apparatus is configured, in the first aspect, such that the processor is configured to further carry out, in conjunction with the memory, the following processes (e) and (f):
(e) displaying the monitoring region in a superimposed manner on a real image that has been captured as an adjustment image by the image capture unit before performing the actual treatment on the substrate, and acquiring an adjustment result in which at least one selected from the group consisting of a position of the monitoring region, a size thereof, and a posture thereof has been adjusted by a user on the basis of the superimposed display; and
(f) setting, on the basis of the adjustment result, at least one selected from the group consisting of the position of the monitoring region, the size thereof, and the posture thereof.

In a third aspect of the present disclosure, the substrate treatment apparatus is configured, in the first or second aspect, to further include: a spin chuck that supports the substrate in a horizontal posture and rotates the substrate; a nozzle configured to eject a treatment liquid from a distal end portion thereof to the substrate supported by the spin chuck; and a nozzle movement mechanism that moves the distal end portion of the nozzle between an origin position of the nozzle, which is a position laterally away from the substrate, and an ejection position thereof, which is a position above the substrate, in conjunction with the memory, the processor being configured to: in the process (a), set the monitoring region three-dimensionally on the basis of three-dimensional design information pertaining to the nozzle; and in the process (d), detect an anomaly related to movement of the nozzle.

A substrate treatment method in accordance with a fourth aspect of the present disclosure is a substrate treatment method carried out by a substrate treatment apparatus configured to perform a predetermined treatment on a substrate, the substrate treatment apparatus including: a recipe storage unit configured to store a recipe that specifies details of an operation of a constituent component of the substrate treatment apparatus and an order of execution, in order to perform the predetermined treatment; an image capture unit provided at a predetermined placement position and configured to capture an image of the component as a real image; and a normal image storage unit, wherein a computer including a processor and a memory is configured to, by causing the processor to operate in conjunction with the memory, carry out the following processes (a) to (d):
(a) setting a monitoring region three-dimensionally on the basis of three-dimensional design information pertaining to the substrate treatment apparatus;
(b) for each of a plurality of timings during a normal operation carried out in accordance with the recipe, generating a normal image by two-dimensionalizing the monitoring region in a view from the placement position;
(c) before performing an actual treatment on the substrate, storing the normal image in the normal image storage unit; and
(d) during working in which the substrate is actually treated in accordance with the recipe, detecting an anomaly on the basis of a difference between the normal image and the real image captured by the image capture unit, the normal image and the real image being synchronized with an operation carried out in accordance with the recipe.

### [Additional remarks]

The present disclosure is not limited to the embodiments described above, but can be altered by a skilled person in the art within the scope of the claims. The present disclosure also encompasses, in its technical scope, any embodiment derived by combining technical means disclosed in differing embodiments as appropriate.

### Reference Signs List

1: substrate treatment apparatus
3: spin chuck
33: nozzle
35: nozzle movement mechanism
45A: processor
45B: memory
53: recipe memory (recipe storage unit)
57: normal image storage unit
W: substrate
CM: camera (image capture unit)
RW, RW1, RW2: monitoring region

## Claims

1. A substrate treatment apparatus configured to perform a predetermined treatment on a substrate, the apparatus comprising:
a recipe storage unit configured to store a recipe that specifies details of an operation of a constituent component of the substrate treatment apparatus and an order of execution, in order to perform the predetermined treatment;
an image capture unit provided at a predetermined placement position and configured to capture an image of the component as a real image;
a normal image storage unit;
a processor; and
a memory,
the processor being configured to carry out, in conjunction with the memory, the following processes (a) to (d):
(a) setting a monitoring region three-dimensionally on the basis of three-dimensional design information pertaining to the substrate treatment apparatus;
(b) for each of a plurality of timings during a normal operation carried out in accordance with the recipe, generating a normal image by two-dimensionalizing the monitoring region in a view from the placement position;
(c) before performing an actual treatment on the substrate, storing the normal image in the normal image storage unit; and
(d) during working in which the substrate is actually treated in accordance with the recipe, detecting an anomaly on the basis of a difference between the normal image and the real image captured by the image capture unit, the normal image and the real image being synchronized with an operation carried out in accordance with the recipe.

2. The substrate treatment apparatus according to claim 1, wherein the processor is configured to further carry out, in conjunction with the memory, the following processes (e) and (f):
(e) displaying the monitoring region in a superimposed manner on a real image that has been captured as an adjustment image by the image capture unit before performing the actual treatment on the substrate, and acquiring an adjustment result in which at least one selected from the group consisting of a position of the monitoring region, a size thereof, and a posture thereof has been adjusted by a user on the basis of the superimposed display; and
(f) setting, on the basis of the adjustment result, at least one selected from the group consisting of the position of the monitoring region, the size thereof, and the posture thereof.

3. The substrate processing apparatus according to claim 1, further comprising:
a spin chuck that supports the substrate in a horizontal posture and rotates the substrate;
a nozzle configured to eject a treatment liquid from a distal end portion thereof to the substrate supported by the spin chuck; and
a nozzle movement mechanism that moves the distal end portion of the nozzle between an origin position of the nozzle, which is a position laterally away from the substrate, and an ejection position thereof, which is a position above the substrate,
in conjunction with the memory, the processor being configured to:
in the process (a), set the monitoring region three-dimensionally on the basis of three-dimensional design information pertaining to the nozzle; and
in the process (d), detect an anomaly related to movement of the nozzle.

4. A substrate treatment method carried out by a substrate treatment apparatus configured to perform a predetermined treatment on a substrate, the substrate treatment apparatus comprising:
a recipe storage unit configured to store a recipe that specifies details of an operation of a constituent component of the substrate treatment apparatus and an order of execution, in order to perform the predetermined treatment;
an image capture unit provided at a predetermined placement position and configured to capture an image of the component as a real image; and
a normal image storage unit, wherein
a computer including a processor and a memory is configured to, by causing the processor to operate in conjunction with the memory, carry out the following processes (a) to (d):
(a) setting a monitoring region three-dimensionally on the basis of three-dimensional design information pertaining to the substrate treatment apparatus;
(b) for each of a plurality of timings during a normal operation carried out in accordance with the recipe, generating a normal image by two-dimensionalizing the monitoring region in a view from the placement position;
(c) before performing an actual treatment on the substrate, storing the normal image in the normal image storage unit; and
(d) during working in which the substrate is actually treated in accordance with the recipe, detecting an anomaly on the basis of a difference between the normal image and the real image captured by the image capture unit, the normal image and the real image being synchronized with an operation carried out in accordance with the recipe.
